## Europäisches Patentamt

## European Patent Office

## Office européen des brevets

(11) Veröffentlichungsnummer: **0 129 045**
**B1**

(12) **EUROPÄISCHE PATENTSCHRIFT**

(45) Veröffentlichungstag der Patentschrift:
**11.03.87**

(51) Int. Cl.⁴: **H 01 L 21/265, H 01 L 21/82, H 01 L 27/10**

(21) Anmeldenummer: **84105353.1**

(22) Anmeldetag: **11.05.84**

(54) **Verfahren zum Herstellen eines integrierten Isolierschicht-Feldeffekttransistors mit zur Gateelektrode selbstausgerichteten Kontakten.**

(30) Priorität: **19.05.83 DE 3318213**

(43) Veröffentlichungstag der Anmeldung:
**27.12.84 Patentblatt 84/52**

(45) Bekanntmachung des Hinweises auf die Patenterteilung:
**11.03.87 Patentblatt 87/11**

(84) Benannte Vertragsstaaten:
**DE FR GB IT NL**

(56) Entgegenhaltungen:
**DE - A - 2 740 549**
**DE - C - 1 764 401**
**US - A - 4 326 329**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Kraft, Wolfgang, Bussardweg 50, D-7800 Freiburg (DE)**

(74) Vertreter: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

### Beschreibung

Die Erfindung beschäftigt sich mit dem Problem, Isolierschicht-Feldeffekttransistoren (MISFETs) für höchstintegrierte Schaltungen (VLSI) herzustellen. Mit der gegenwärtigen Technik ist es möglich, höchstintegrierte Schaltungen mit Isolierschicht-Feldeffekttransistoren herzustellen, deren Kanallänge (L) etwa 1 μm beträgt, wie es beispielsweise aus «IEEE Journal of Solid-State Circuits» Bd. SC-15, Nr. 4 (Aug. 1980) Seiten 417 bis 423 und dem Jahresbericht «Semiconductor Technologies, 1982», Herausgeber J. Nishizawa, Seiten 280 bis 295, bekannt ist. Dabei werden solche Verfahren angewendet, die sich durch eine Selbstausrichtung (self-aligning) auszeichnen.

Bei derartigen Verfahren wird insbesondere stets zunächst die Gateelektrode einschliesslich ihrer Gateisolatorschicht hergestellt und diese dann bei einem Implantationsprozess der Dotierung von Source- und Drain-Zone als Implantationsmaske verwendet, wie es auch für den Si-Gate-Prozess nach «Electronics» vom 29.9.1969, Seiten 88 bis 94 für einen Diffusionsprozess unter Verwendung der Gateelektrode als Diffusionsmaske charakteristisch ist. Zur Erzielung einer Selbstausrichtung des Sourcekontaktes und des Drainkontaktes zur Gateelektrode wird letztere aus einem oxidierbaren Material, insbesondere polykristallinem Silizium, herausgeätzt. Nach Herstellung der Kontaktierungsöffnungen wird eine Kontaktierungsschicht aufgebracht, aus der unter Anwendung eines photolithographischen Ätzprozesses die Kontakte einschliesslich der Leitbahnen oder auch die kontaktierenden Leitbahnen herausgeätzt werden.

Die Verfahrensweise der Verwendung der Gateelektrode als Maske bei der Herstellung von Sourcezone und Drainzone hat aber bei der Herstellung von integrierten Isolierschicht-Feldeffekttransistoren für höchstintegrierte Schaltungen Nachteile, welche um so stärker wiegen, je kleiner die Kanallänge ist. So wurde festgestellt, dass die bei der Herausätzung der Gateelektrode aus einer Elektrodenmaterialschicht auftretenden relativen Schwankungen der Kanallängen, also die der Abstände der Sourcezonen zu den jeweils benachbarten Drainzonen, aufgrund der nicht zu vermeidenden Schwankungen bei der Unterätzung der den Gateelektrodenbereich bedeckenden Maskierung um so grösser werden, je kürzere Kanallängen, also um so kleinere Isolierschicht-Feldeffekttransistoren realisiert werden sollen. Wird eine dünnere Elektrodenmaterialschicht verwendet, so werden diese Schwankungen zwar einerseits kleiner, andererseits wird aber der Schichtwiderstand von Elektroden und den ebenfalls aus dem Elektrodenmaterial bestehenden Zuleitungen unerwünscht gross. Auch schafft eine Verwendung von den bekannten oxidierbaren Siliziden als Elektrodenmaterial, deren Leitfähigkeit ein mehrfaches grösser ist als dotiertes polykristallines Silizium, in diesem Zusammenhang grundsätzlich keine Abhilfe.

Die Erfindung geht von dem Gedanken aus, bei der Herstellung von integrierten Isolierschicht-Feldeffekttransistoren nach den bekannten Verfahren der beiden eingangs genannten Literaturstellen zwar die Verfahrensweise der Herstellung von zur Gateelektrode selbstausgerichteten Kontakten beizubehalten, jedoch die Verfahrensweise der Herstellung von zur Gateelektrode selbstausgerichteten Zonen unter Verwendung der Gateelektrode selbst als Maske aufzugeben, obwohl gerade hinsichtlich der Anwendung der Si-Gate-Technik in der Fachwelt die Ansicht vertreten wird, dass gerade diese Technik besonders für die Verkleinerung von integrierten Isolierschicht-Feldeffekttransistoren besonders geeignet ist, wie es sich beispielsweise aus der oben genannten Zeitschrift «Electronics» vom 29.7.1969, Seiten 88 bis 94 ergibt.

Die Erfindung geht von der Erkenntnis aus, dass eine Oxidationsmaskierungsschicht, insbesondere aus Siliziumnitrid, zur Abgrenzung des Gatebereichs eines Isolierschicht-Feldeffekttransistors für eine hochintegrierte Schaltung besser geeignet ist als beispielsweise eine Gateelektrodenschicht aus polykristallinem Silizium, da einerseits schon eine Siliziumnitridschicht mit einer Schichtdicke mit etwa 15 nm gegen eine Oxidation eines Siliziumsubstrats vollständig schützt, andererseits aber eine Schichtdicke von 300 nm für eine hochdotierte Si-Gate-Elektrode überschritten werden muss, um einigermassen brauchbare Leitwerte der Elektroden und Leitbahnen zu erhalten. Dieser Sachverhalt beruht darauf, dass aufgrund der erwähnten Unterätzung nach einer Maskierung grundsätzlich eine dünne Schicht scharfkantiger und definierter ätzbar ist als eine demgegenüber relativ dicke Schicht.

Entsprechend der oben genannten Erkenntnis wurde das bekannte Verfahren der DE-PS 1764 401 in Erwägung gezogen. Bei diesem Verfahren, bei dem die Schwankungen der Überlappungskapazitäten der Gateelektrode zur Sourcezone und Drainzone aufgrund der relativ grossen Dicke der Isolierschichten auf diesen Zonen gering sind, wird auf die Oberfläche des Substrats eines Implantations-Feldeffekttransistors eine Oxidationsmaskierungsschicht aufgebracht, welche den Gatebereich bedeckt. Es erfolgt ein thermischer Oxidationsprozess, so dass die Substratoberfläche mit Ausnahme des Gatebereichs unter Bildung einer Isolierschicht oxidiert wird. In dieser Isolierschicht aus Siliziumdioxid werden nun beiderseits der Oxidmaskierungsschicht Diffusionsöffnungen entsprechend der Bereiche der Sourcezone und der Drainzone hergestellt. Es erfolgt dann ein Diffusionsprozess von Dotierungen der Zonen, wonach die Reste der Isolierschicht aus Siliziumdioxid entfernt werden. Danach wird zur Herstellung einer Dickoxidschicht abermals oxidiert. Innerhalb der Zonenbereiche werden auf photolithographischem Wege Kontaktierungsöffnungen in der Isolierschicht angebracht und schliesslich sämtliche Elektroden einschliesslich der Gateelektrode nach Ersatz der den Gatebereich bedeckenden Oxidationsmaskierungsschicht durch ein thermisch erzeugtes Gateoxid hergestellt.

Da die Anwendung des bekannten Verfahrens der vorstehend genannten DE-PS 1 764 401 bisher nicht zum Herstellen der integrierten Isolierschicht-Feldeffekttransistoren von höchstintegrierten Schaltkreisen in Erwägung gezogen wurde, wird bei dem Verfahren der Erfindung ausgegangen von dem bekannten Verfahren der eingangs genannten Literaturstellen. Bei diesen Verfahren wird zum Herstellen eines integrierten Isolierschicht-Feldeffekttransistors mit zur Gateelektrode selbstausgerichteten Kontakten an einer Sourcezone und einer Drainzone, welche in ein halbleitendes Substrat eingebracht wurden, die Gateelektrode durch thermische Oxidation mit Isoliermaterial überzogen. Anschliessend werden nach der Herstellung von Kontaktöffnungen in den die Zonen bedeckenden Isolierschichten die Kontakte an den Zonen angebracht, welche gegen die Gateelektrode durch das Isoliermaterial getrennt sind.

Die Erfindung betrifft ein solches Verfahren gemäss dem Oberbegriff des Anspruchs 1.

Aufgabe der Erfindung ist, bei vergleichbaren gleichen Abmessungen des Gatebereichs diesen schärfer zu begrenzen und dadurch kleinere Abmessungen realisieren zu können.

Diese Aufgabe wird durch die im kennzeichnenden Teil des Anspruchs 1 genannten Massnahmen gelöst.

Vorzugsweise wird bei dem Verfahren der Erfindung eine als Implantationsmaske geeignete Oxidationsmaskierungsschicht aufgebracht, welche aus einer oberen Teilschicht, vorzugsweise aus Siliziumnitrid, und einer demgegenüber selektiv ätzbaren unteren Teilschicht besteht, welche als Gateisolatorschicht verwendbar ist, so dass nach Entfernung der oberen Teilschicht das Gateelektrodenmaterial auf die untere Teilschicht aufgebracht werden kann.

Vor dem Aufbringen der als Implantationsmaske geeigneten Oxidationsmaskierungsschicht kann unter Verwendung einer lediglich zum Zwecke der Oxidationsmaskierung geeigneten Schicht der Feldbereich ausserhalb der Zonen- und Gatebereiche zur Ausbildung einer Dickoxidschicht oxidiert werden. Unter dieser Dickoxidschicht kann zur Erhöhung der Feldschwellspannung eine vom Leitungstyp des Substrats hochdotierte Schicht vorgesehen werden. Zu diesem Zwecke werden in bekannter Weise in den Feldbereich Ionen vom Leitungstyp des Substrats implantiert, wobei die Zonenbereiche und die Gatebereiche der Isolierschicht-Feldeffekttransistoren der integrierten Festkörperschaltungen, welche in der Mehrzahl an einer zu zerteilenden Halbleiterplatte hergestellt werden, maskiert sind. Eine solche Maskierung kann beispielsweise durch eine Photolackmaske erfolgen.

Im Interesse der Scharfkantigkeit der Abbildung beim ersten Photolackprozess, mit dessen Hilfe die den Gatebereich abdeckende Oxidationsmaskierungsschicht hergestellt wird, soll aber möglichst von einer ebenen Substratfläche ausgegangen werden, um Streuungen und Reflexionen an unebenen Flächenteilen zu vermeiden, welche die Abbildungsschärfe beeinträchtigen könnten. Aus diesem Grund erfolgt bei dem im folgenden anhand der Figuren beschriebenen Ausführungsbeispiel die Herstellung der Dickoxidschicht erst in einem späteren Herstellungsstadium.

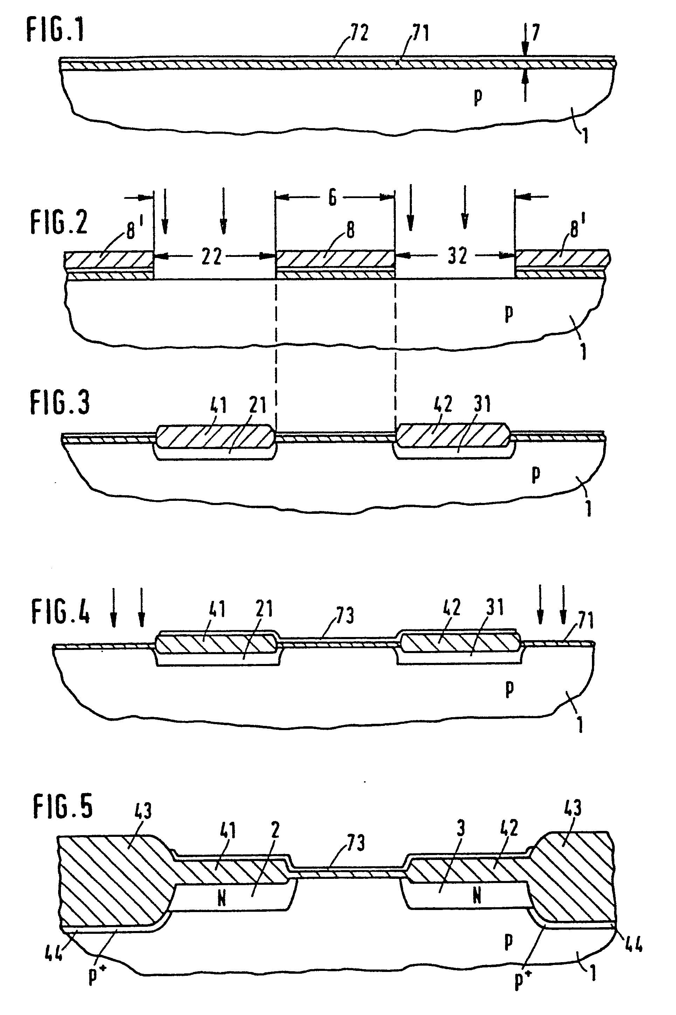

Die Fig. 1 bis 9 zeigen Teilschnittansichten durch ein plattenförmiges Si-Substrat einer hochintegrierten MIS-Festkörperschaltung und dienen zur Veranschaulichung der Herstellungsstadien des Verfahrens nach der Erfindung.

Entsprechend dem Ausführungsbeispiel des Verfahrens nach der Erfindung wird von einem p-dotierten Substrat 1 aus Silizium ausgegangen und entsprechend der Fig. 1 oberflächlich die als Implantationsmaske für den anhand der Fig. 2 veranschaulichten Implantationsprozess geeignete Oxidationsmaskierungsschicht 7 aufgebracht, welche aus einer unteren Teilschicht 71 besteht, welche später als Gateisolatorschicht 5 (vgl. Fig. 8) verwendet wird und vorzugsweise aus thermisch erzeugtem Siliziumdioxid besteht. Auf diese untere Teilschicht 71 wird die eigentliche gegen die Oxidation wirksame obere Teilschicht 72 aus Siliziumnitrid aufgebracht. Beide sind in der Dicke derart bemessen, dass der anhand der Fig. 2 veranschaulichte Implantationsprozess von Dotierungen der Sourcezone 21 und Drainzone 31 (vgl. Fig. 3) maskiert wird. Die Dicke der gesamten Oxidationsmaskierungsschicht 7 richtet sich bekanntlich nach der Beschleunigungsspannung und der Art der zu implantierenden Ionen. Aufgrund der Doppelstruktur der Oxidationsmaskierungsschicht 7 und der in weiten Grenzen wählbaren Beschleunigungsspannung bereitet es keine Schwierigkeiten, eine Oxidationsmaskierungsschicht 7 aufzubringen, die als Implantationsmaske brauchbar ist und deren untere Teilschicht 71 zugleich als Gateoxidschicht verwendbar ist.

Auf diese Oxidationsmaskierungsschicht 7 wird eine erste Photolackmaske 8, 8' aufgebracht, welche die Zonenbereiche 22 und 32 freilässt. Unter Verwendung dieser ersten Photolackmaske als Ätzmaske wird die Substratoberfläche innerhalb der Öffnungen der Photolackmaske 8, 8' freigelegt und anschliessend der Implantationsprozess für die Dotierungen von Sourcezone und Drainzone gemäss der Fig. 2 durchgeführt.

Nach Durchführung dieses Implantationsprozesses und einer thermischen Oxidation zur Herstellung der die Zonenbereiche 22 und 32 bedeckenden Isolierschichten 41 und 42 wird eine Anordnung gemäss der Fig. 3 erhalten.

Anschliessend wird die obere aus Siliziumnitrid bestehende Teilschicht 72 der Oxidationsmaskierungsschicht 7 durch einen Ätzprozess, vorzugsweise in bekanntner Weise aus einer reaktiven Gasphase, entfernt und eine weitere Oxidationsmaskierungsschicht 73 aufgebracht, welche sowohl die Zonenbereiche 22 und 32 als auch den Gatebereich 6 bedeckt. Es erfolgt nun eine Implantation von Dotierungen des Leitungstyps des Substrats 1, wie die Fig. 4 veranschaulicht, wobei die Beschleunigungsspannung derart gewählt wird, dass die untere Teilschicht 71 durchdrungen wird.

Die Dickoxidschicht 43 wird anschliessend in bekannter Weise durch thermische Oxidation hergestellt, wobei der Oxidation des Substrats die Diffusion der hochdotierten Schicht 44 vom Leitungstyp des Substrats 1 vorausläuft. Bei diesem Oxidationsprozess verhindert die weitere Oxidationsmaskierungsschicht 72 das Eindringen von Sauerstoff in den Gatebereich und die Zonenbereiche. Es wird eine Anordnung gemäss der Fig. 5 erhalten.

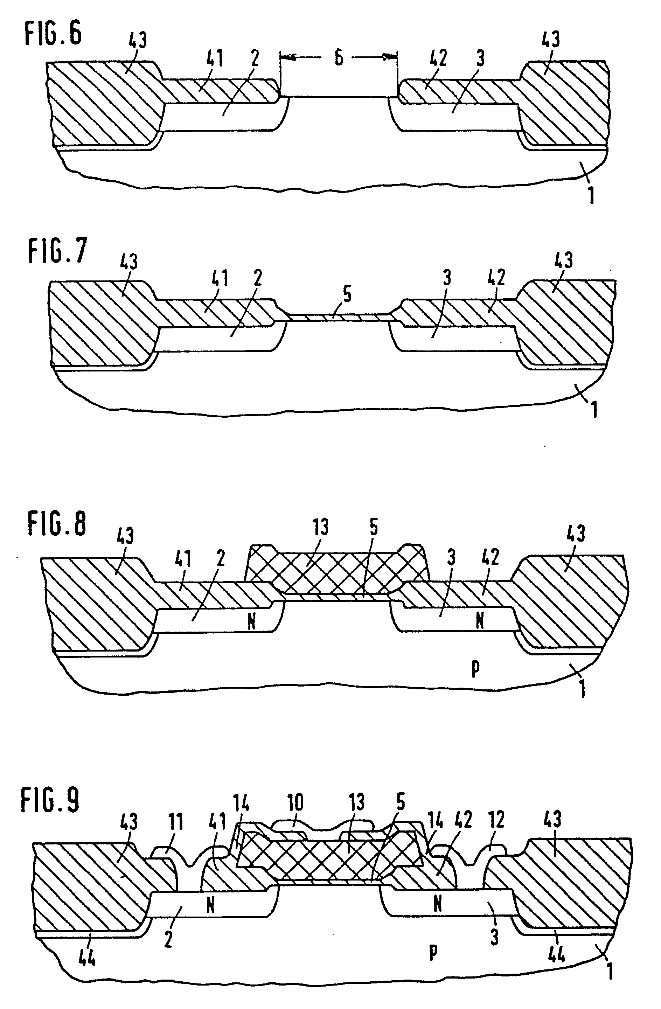

Nach Abätzen der weiteren Oxidationsmaskierungsschicht 73 und Freilegung des Gatebereichs 6 kann nun eine Anordnung der Fig. 6 erhalten werden, bei der das Gateoxid 5 der Fig. 7 durch Oxidation zu erzeugen ist. Günstiger ist jedoch, eine aus einer oberen Teilschicht 72 und einer unteren Teilschicht 71 bestehende Oxidationsmaskierungsschicht 7 aufzubringen, wobei die untere Teilschicht 71 in der Dicke derart zu bemessen ist, dass sie als Gateisolatorschicht 5 verwendet werden kann. Die obere aus Siliziumnitrid bestehende Teilschicht 72 dient in diesem Falle als Schutzschicht der Gateisolatorschicht 5 bei den vorhergehenden Oxidationsprozessen.

Bei der Anordnung der Fig. 6 kann vor Erzeugung der Gateisolatorschicht 5 eine Implantation im Gatebereich 6 zur Einstellung des Schwellwertes und/oder der Kennlinien erfolgen, wobei die Dickoxidschicht 43 und die Isolierschichten 41 und 42 maskierend wirken. Eine solche Implantation kann auch in einem vorherigen Stadium erfolgen, beispielsweise vor dem Aufbringen der weiteren Oxidationsmaskierungsschicht 73 (vgl. Fig. 4), wobei der Feldbereich mit einer Photolackmaske gegen die Implantation der Ionen geschützt wird.

Auf die Anordnung der Fig. 7 mit der Gateisolatorschicht 5 wird nun eine Schicht aus dem Material der Gateelektrode, beispielsweise dotiertes Silizium oder auch einer der bekannten Silizide, aufgebracht, welche oberflächlich mit Isoliermaterial überzogen werden kann. Aus dieser Materialschicht wird die Gateelektrode 13 mit den zur Verschaltung erforderlichen Leitbahnen herausgeätzt, wozu eine Photolackmaske auf der Materialschicht aufgebracht wird und die freiliegenden Teile der Materialschicht, vorzugsweise durch einen Trockenätzprozess aus der Gasphase, entfernt werden. Danach ergibt sich die Anordnung gemäss der Fig. 8.

Anschliessend erfolgt ein thermischer Oxidationsprozess, wobei die freiliegenden Teile der Gateelektrode 13 und natürlich auch die der Leiterbahnen oberflächlich mit Isoliermaterial 14 bedeckt werden. Danach erfolgt ein photolithographischer Ätzprozess zum Herstellen der Kontaktierungsöffnungen für die Kontakte 11 und 12 an den Zonen 2 und 3, wobei auch eine Öffnung an der Gateelektrode oder an deren Verlängerung angebracht werden kann, an der der Gatekontakt 10 angebracht wird.

Anhand der Fig. 9 ist ohne weiteres zu erkennen, dass aufgrund der selbstausrichtenden Verfahrensweise der Herstellung der Kontakte 11 und 12 an den Zonen einerseits und andererseits zur Gateelektrode 13 der photolithographische Ätzprozess zur Herstellung der Gateelektrode 13 unkritisch ist. Dieser photolithographische Ätzprozess ist aber auch hinsichtlich der Überlappungskapazitäten unkritisch, da die die Isolierschichten 41 und 42 überlappenden Teile der Gateelektrode 13 aufgrund der dort vorhandenen im Verhältnis zur Gateisolatorschicht 5 wesentlich dickeren Isolierschichten 41 und 42 zu den Überlappungskapazitäten praktisch nicht beitragen.

**Patentansprüche**

1. Verfahren zum Herstellen eines integrierten MIS-Feldeffekttransistors mit zur Gateelektrode selbstausgerichteten Kontakten an einer Sourcezone (2) und einer Drainzone (3), welche Zonen (2, 3) in ein halbleitendes Substrat (1) eingebracht sind und bei welchem Verfahren die Gateelektrode (13) durch thermische Oxidation mit Isoliermaterial (14) überzogen wird und dann nach Herstellung von Kontaktöffnungen in den die Zonen (2, 3) bedeckenden Isolierschichten (41, 42) die Kontakte (11, 12), welche gegen die Gateelektrode (13) durch das Isoliermaterial (14) getrennt sind, an den Zonen (2, 3) angebracht werden, dadurch gekennzeichnet,

— dass auf die Oberfläche des Substrats (1) eine als Ionenimplantationsmaske geeignete Oxidationsmaskierungsschicht (7) aufgebracht wird, auf der eine erste Photolackmaske (8', 8) aufgebracht wird, welche die Zonenbereiche (22, 32) freilässt,

— dass die von der ersten Photolackmaske (8, 8') nicht bedeckten Teile der Oxidationsmaskierungsschicht (7) entfernt werden und dann in die so freigelegte Substratoberfläche Ionen vom Leitungstyp der Zonen (2, 3) implantiert werden,

— dass dann eine thermische Oxidation zur Herstellung der Isolierschichten (41, 42) erfolgt, welche die Zonenbereiche (22, 32) bedecken und

— dass nach der Herstellung und Oxidation der Gateelektrode (13) die Kontakte (11, 12) durch die Kontaktöffnungen, welche mittels einer zweiten Photolackmaske hergestellt werden, an den Zonen (2, 3) angebracht werden.

2. Verfahren nach Anspruch 1, dadurch gekennzeichnet,

— dass eine Oxidationsmaskierungsschicht (7) aufgebracht wird, welche aus einer oberen Teilschicht (72) und einer demgegenüber selektiv ätzbaren unteren Teilschicht (71) besteht, welche als Gateisolatorschicht (5) verwendbar ist und

— dass die obere Teilschicht (72) vor der Herstellung der Gateelektrode (13) entfernt wird.

3. Verfahren nach Anspruch 1, dadurch gekennzeichnet,

— dass vor der Herstellung der Gateelektrode (13) der Gatebereich (6) des Substrats (1) durch Abätzen der Oxidationsmaskierungsschicht (7) freigelegt wird und dann die Gateisolatorschicht (5) erzeugt wird.

4. Verfahren nach einem der Ansprüche 1 bis 3, dadurch gekennzeichnet,

— dass nach der Herstellung der die Zonen bedeckenden Isolierschichten (41, 42) zumindest die obere Teilschicht (72) der Oxidationsmaskierungsschicht (7) entfernt wird,

— dass danach die Zonenbereiche (22, 32) und der Gatebereich (6) mit einer weiteren Oxidationsmaskierungsschicht (73) bedeckt wird und

— dass anschliessend der ausserhalb der weiteren Oxidationsmaskierungsschicht (73) liegende Feldbereich des Substrats (1) mittels thermischer Oxidation mit einer Dickoxidschicht (43) bedeckt wird.

5. Verfahren nach Anspruch 4, dadurch gekennzeichnet, dass vor der Erzeugung der Dickoxidschicht (43) in den Feldbereich Ionen vom Leitungstyp des Substrats (1) implantiert werden.

**Claims**

1. Process for manufacturing an integrated MIS field-effect transistor comprising contacts at a source region (2) and at a drain region (3) which contacts are self-aligned with respect to the gate electrode, with said regions (2, 3) being introduced into a semiconducting substrate (1), and with the gate electrode (13), by way of thermal oxidation, being coated with an insulating material (14), and which process, following the manufacture of contact windows in the insulator layers (41, 42) covering said regions (2, 3), the contacts (11, 12) which are separated from said gate electrode (13) by said insulating material (14), are attached to said regions (2, 3), characterized in

— that on the surface of the substrate (1) there is deposited an oxidation masking layer (7) suitable for being used as an ion implantation mask, on which a first photoresist mask (8, 8') is deposited by leaving free the region areas (22, 32),

— that the portions of said oxidation masking layer (7) which are not covered by said first photoresist mask (8', 8) are removed, and that then, into the thus exposed substrate surface, ions of the conductivity type of said regions (2, 3) are implanted,

— that then there is effected a thermal oxidation for producing the insulator layers (41, 42) covering said region areas (22, 32), and

— that the contacts (11, 12), following the manufacture and oxidation of said gate electrode (13) are attached to said regions (2, 3) through the contact windows which are produced with the aid of a second photoresist mask.

2. A process as claimed in claim 1, characterized in

— that an oxidation masking layer (7) is deposited which consists of an upper partial layer (72) and of a lower partial layer (71) which, as compared to said upper partial layer (72) is selectively etchable, and which is capable of being used as the gate insulator layer (5), and

— that said upper partial layer (72) is removed prior to the manufacture of said gate electrode (13).

3. A process as claimed in claim 1, characterized in that prior to the manufacture of said gate electrode (13), the gate area (6) on said substrate (1) is exposed by etching away said oxidation masking layer (7), and that thereafter said gate insulator layer (5) is produced.

4. A process as claimed in any one of claims 1 to 3, characterized in

— that after said insulator layers (41, 42) covering the regions, have been produced, there is removed at least the upper partial layer (72) of said oxidation masking layer (7),

— that thereafter the region areas (22, 32) and said gate ares (6) are covered with a further oxidation masking layer (73), and

— that thereafter the field area of said substrate (1) lying outside said further oxidation masking layer (73), is covered by way of thermal oxidation with a thick oxide layer (43).

5. A process as claimed in claim 4, characterized in that prior to the production of said thick oxide layer (43), ions of the substrate (1) conductivity type are implanted into said field area.

**Revendications**

1. Procédé pour la fabrication d'un transistor à effet de champ MIS intégré comprenant des contacts auto-alignés par rapport à l'électrode de grille, dans une zone de source (2) et une zone de drain (3), ces zones (2, 3) étant introduites dans un substrat semi-conducteur (1), procédé dans lequel l'électrode de grille (13) est recouverte d'un matériau isolant (14) par oxydation thermique, et dans lequel, après la réalisation des fenêtres de contact dans les couches isolantes (41, 42) recouvrant ces zones (2, 3), les contacts (11, 12), qui sont séparés de cette électrode de grille (13) par ledit matériau isolant (14), sont fixés auxdites zones (2, 3), caractérisé en ce que:

— à la surface du substrat (1) est déposée une couche de masquage d'oxydation (7) pouvant être utilisée comme couche de masquage d'implantation, sur laquelle est déposée un premier masque en résine photosensible (8, 8') laissant libre les emplacements des zones (22, 32),

— les parties de ladite couche de masquage d'oxydation (7) non recouvertes par le premier masque en résine photosensible (8, 8') sont enlevées et, ensuite, des ions du type de conductibilité desdites zones (2, 3) sont implantés dans la surface de substrat ainsi exposée,

— il est ensuite procédé à une oxydation thermique pour la production des couches isolantes (41, 42) recouvrant lesdits emplacements de zones (22, 32), et

— les contacts (11, 12) après la réalisation et l'oxydation de ladite électrode de grille (13), sont fixés auxdites zones (2, 3), à travers les fenêtres de contact produites à l'aide d'un deuxième masque en résine photosensible.

2. Procédé selon la revendication 1, caractérisé en ce que:

— il est déposé une couche de masquage d'oxydation (7) consistant en une couche partielle supérieure (72) et une couche partielle inférieure (71) qui peut faire l'objet d'une oxydation sélective, par rapport à la précédente, et qui peut être utilisée comme couche d'isolement de grille (5), et

— la couche partielle supérieure (72) est enlevée avant la réalisation de ladite électrode de grille (13).

3. Procédé selon la revendication 1, caractérisé en ce que, avant la réalisation de l'électrode de grille (13), l'emplacement de grille (6) sur ledit substrat (1) est exposé par attaque de la couche de masquage d'oxydation (7), ladite couche d'isolement de grille (5) étant produite ensuite.

4. Procédé selon l'une quelconque des revendications 1 à 3, caractérisé en ce que:

— après qu'aient été produites les couches d'isolement (41, 42) recouvrant les zones, on enlève au moins la couche partielle supérieure (72) de ladite couche de masquage d'oxydation (7),

— ensuite, les emplacements des zones (22, 32) et l'emplacement de grille (6) sont recouverts d'une autre couche de masquage d'oxydation (73), et

— ensuite, la région de champ dudit substrat (1) se trouvant en dehors de ladite autre couche de masquage d'oxydation (73) est recouverte d'une couche d'oxyde épaisse (43) par oxydation thermique.

5. Procédé selon la revendication 4, caractérisé en ce que, avant la production de cette couche d'oxyde épaisse (43), des ions du type de conductibilité du substrat sont implantés dans ladite région de champ.

FIG.1

FIG.2

FIG.3

FIG.4

FIG.5

**FIG.6**

**FIG.7**

**FIG.8**

**FIG.9**